# EUROPÄISCHE PATENTANMELDUNG

(11) **EP 4 124 607 A1**
(43) Veröffentlichungstag der Anmeldung: **01.02.2023**
(21) Anmeldenummer: 22187578.4
(22) Anmeldetag: 28.07.2022
(51) Int. Cl.: C03C 27/08, B23K 26/20, B81C 1/00, C03C 21/00, C03B 23/20, C03B 23/24

(54) **VERFAHREN ZUM STOFFSCHLÜSSIGEN FÜGEN VON GLASELEMENTEN, GLASBAUTEIL SOWIE GEHÄUSE UND VAKUUMISOLIERGLASSCHEIBE UMFASSEND DAS GLASBAUTEIL**

(30) Priorität: 28.07.2021 DE 102021208160
(71) Anmelder: Fraunhofer-Gesellschaft zur Förderung der angewandten Forschung e.V., 80686 München (DE); Technische Universität Berlin, 10623 Berlin (DE)
(72) Erfinder: Wachholz,, Philipp, 13355 Berlin (DE); Arndt-Staufenbiel,, Norbert, 13355 Berlin (DE); Töpper,, Dr. Michael, 13355 Berlin (DE); Schwietering,, Julian, 10623 Berlin (DE)
(74) Vertreter: Pfenning, Meinig & Partner mbB

(57) **Zusammenfassung**

Die vorliegende Anmeldung betrifft ein Verfahren zum stoffschlüssigen Fügen von Glaselementen, ein Glasbauteil, ein Gehäuse und eine Vakuumisolierglasscheibe. Das Verfahren umfasst die folgenden Schritte
- Bereitstellen eines ersten und eines zweiten Glaselements, wobei jedes der Glaselemente zumindest einen Fügebereich mit einer zu fügenden Außenkante aufweist,
- Einbringen eines metallischen Materials in das erste Glaselement im Bereich des Fügebereichs des ersten Glaselements,
- Aufeinandersetzen des ersten und zweiten Glaselements, derart, dass sich das erste und das zweite Glaselement an zumindest einer zu fügenden Außenkante des jeweiligen Fügebereichs berühren,
- Erhitzen des metallischen Materials im ersten Glaselement, sodass das Glaselement im Bereich des Fügebereichs des ersten Glaselements zumindest teilweise schmilzt, sodass eine stoffschlüssige Verbindung zwischen dem ersten und dem zweiten Glaselement entsteht.

## Beschreibung

Die vorliegende Anmeldung betrifft ein Verfahren zum stoffschlüssigen Fügen von Glaselementen. Ferner betrifft sie ein Glasbauteil sowie ein Gehäuse und eine Vakuumisolierglasscheibe umfassend ein entsprechendes Glasbauteil.

Glasbauteile sind in vielen industriellen Anwendungen insbesondere aufgrund ihrer optischen Transparenz vorteilhaft gegenüber anderen Materialien.

Insbesondere für Gehäuse kann es wichtig sein, dass hermetisch abgedichtete Innenräume vorliegen, die sensible Bauteile vor Verschmutzung und äußeren Einflüssen schützen können.

Um einen derartigen abgedichteten Innenraum herzustellen müssen zwei oder mehr Glasbauteile gefügt werden.

Dafür sind verschiedene Fügeverfahren bekannt. Konventionelle Schmelzverfahren, also insbesondere Schmelzverfahren bei denen große Bereiche des Glases, oder das gesamte Glas, erhitzt werden beispielsweise haben jedoch den Nachteil, dass hohe Temperaturen integrierte Bauteile zerstören oder beschädigen können. Glaslote müssen lokal aufgebracht werden und benötigen eine große Kontaktfläche. Dies hat den Nachteil, dass diese Technik nur für größere Bauteile möglich ist und eine Miniaturisierung erschwert. Metallische Löttechniken benötigen die Abscheidung eines Lotes, das aufgrund der unterschiedlichen thermischen Ausdehnungskoeffizienten zu starken mechanischen Spannungen führen kann. Klebetechniken erreichen keine hohen Hermetizitätsanforderungen. Anodisches Bonden benötigt sowohl hohe elektrische Spannungen von typischerweise 800 V, als auch hohe Temperaturen von bis zu 600°C. Solch hohe Temperaturen und Spannungen würden Sensoren in einem Package zerstören. Beim Schweißen mittels C02-, Nd:YAG- oder Diodenlasern muss die geringe Wärmeleitfähigkeit des Glases berücksichtigt werden. Sie erzeugen bei lokaler Erhitzung hohe Temperaturgradienten, die zum Bruch führen können. Zudem ist der Arbeitsabstand sehr gering.

Daher liegt der vorliegenden Erfindung die Aufgabe zugrunde, ein Verfahren vorzuschlagen, das zumindest einen oder einige der vorerwähnten Nachteile überwindet. Ferner kann es Aufgabe der vorliegenden Erfindung sein ein Glasbauteil, ein Gehäuse und/oder eine Vakuumisolierglasscheibe vorzuschlagen, das bzw. die zumindest einen oder einige der vorerwähnten Nachteile überwindet.

Zumindest eine dieser Aufgaben wird gelöst durch ein Verfahren gemäß Anspruch 1 und/oder durch ein Glasbauteil, ein Gehäuse und/oder eine Vakuumisolierglasscheibe gemäß einem der nebengeordneten Ansprüche.

Das erfindungsgemäße Verfahren dient insbesondere zum stoffschlüssigen Fügen von Glaselementen. Das Verfahren umfasst den Schritt
- Bereitstellen eines ersten und eines zweiten Glaselements, wobei jedes der Glaselemente zumindest einen Fügebereich mit einer zu fügenden Außenkante aufweist.

Vorzugsweise umfasst das Verfahren ferner den Schritt
- Einbringen eines metallischen Materials in das erste Glaselement im Bereich des Fügebereichs des ersten Glaselements.

Alternativ kann das erste Glaselement bereits metallisches Material im Bereich des Fügebereichs umfassen.

Das erste und das zweite Glaselement werden derart aufeinandergesetzt, dass sich das erste und das zweite Glaselement an zumindest einer zu fügenden Außenkante des jeweiligen Fügebereichs berühren.

Das metallisches Material im Fügebereich des ersten Glaselements, vorzugsweise das eingebrachte metallische Material, wird derart erhitzt, dass das Glaselement im Bereich des Fügebereichs des ersten Glaselements zumindest teilweise schmilzt, sodass eine stoffschlüssige Verbindung zwischen dem ersten und dem zweiten Glaselement entsteht.

So können verschiedenen Bausteine aus Glas, ohne die Verwendung von Hilfsstoffen zwischen den aufeinandergesetzten Glasoberflächen, stoffschlüssig miteinander verbunden werden.

In einer Ausführungsform des Verfahrens kann das Erhitzen des metallischen Materials durch Einbringen von elektromagnetischen Wellen und/oder Anlegen eines Stroms an das metallische Material erfolgen. Das erhitzte metallische Material kann metallische Strukturen bilden. Das metallische Material bzw. die metallischen Strukturen können genutzt werden, um lokal elektromagnetische Wellen zu absorbieren. Dies kann den Vorteil haben, dass das Glas lediglich lokal erhitzt wird. Dies kann zu einem lokalen Schmelzen des Glases des ersten und/oder des ersten und zweiten Glaselements führen. So können das erste und das zweite Glaselement lokal gefügt werden, ohne dass ein Bauteil, das in einem Innenraum zwischen dem ersten und dem zweiten Glaselement angeordnet werden kann, ebenfalls erhitzt wird oder dass ein Bauteil, das in einem Innenraum zwischen dem ersten und dem zweiten Glaselement angeordnet werden kann, lediglich in geringem Maße erhitzt wird. So können durch Hitze hervorgerufene Beschädigungen von Bauteilen, die in einem Innenraum bzw. nahe des Fügebereichs des ersten und zweiten Glaselements angeordnet sind vermieden und/oder vermindert werden.

In einer Ausführungsform kann das Erhitzen derart erfolgen, dass das zweite Glaselement im Fügebereich erhitzt wird und zumindest teilweise schmilzt. Alternativ kann vorgesehen sein, dass lediglich das erste Glaselement im Fügebereich zumindest teilweise schmilzt.

Das metallische Material kann beispielsweise auf eine Temperatur von mindestens 100°C oder mindestens 300°C oder mindestens 1000°C erhitzt werden. Das metallische Material kann beispielsweise auf eine Temperatur von maximal 4000°C oder maximal 3000°C oder maximal 2000°C erhitzt werden.

In einer Ausführungsform des Verfahrens werden elektromagnetische Wellen mittels einer Lichtquelle, vorzugsweise einem Laser oder mittels einer Mikrowellenstrahlungsquelle, in das erste Glaselement eingebracht. Beispielsweise kann ein CW-Laser oder ein Laserbonder verwendet werden. Weitere Beispiele für Lichtquellen zum Einbringen von elektromagnetischer Strahlung sind fokussierte kohärente Strahlung, z.B. Laser für Glaslötprozesse, nicht fokussierte kohärente Strahlung, fokussierte inkohärente Strahlung, nicht fokussierte inkohärente Strahlung, z.B. Blitzlampentemperung.

Alternativ oder zusätzlich kann das Erhitzen der metallischen Struktur mittels Mikrowellenstrahlung oder durch elektrothermische Absorption vorgenommen werden.

So kann das erste Glaselement mit dem zweiten Glaselement verschweißt werden. In dem Fügebereich kann das erste Glaselement mit dem zweiten Glaselement über eine Schweißnaht zwischen dem ersten und dem zweiten Glaselement verbunden werden. So kann beispielsweise ein Innenraum zwischen dem ersten und dem zweiten Glaselement gebildet werden, der gegenüber einer Umgebung gasdicht, insbesondere hermetisch, abgedichtet ist. Der Innenraum kann beispielsweise eine Vakuumkammer, insbesondere eine Feinvakuumkammer oder eine Hochvakuumkammer oder eine Ultrahochvakuumkammer sein. Bei einem Feinvakuum kann der Druck in dem Innenraum beispielsweise zwischen 1 mbar und 10⁻³ mbar liegen. Bei einem Hochvakuum kann der Druck in dem Innenraum beispielsweise zwischen 10⁻³ mbar und 10⁻⁸ mbar liegen. Bei einem Ultrahochvakuum kann der Druck in dem Innenraum beispielsweise zwischen 10⁻⁸mbar und 10⁻¹¹ mbar liegen.

Das erste und/oder das zweite Glaselement können/kann metallisches Material umfassen. Das metallische Material kann bereits in dem ersten und/oder zweiten Glaselement vorgesehen sein. Alternativ kann das metallische Material in das erste und/oder das zweite Material eingebracht werden.

Beispielsweise können Ionen in das erste und/oder das zweite Glaselement eingebracht werden. Die Ionen können beispielsweise mittels lonenaustausch und/oder Ionenimplantation in das erste und/oder in das zweite Glaselement eingebracht werden. Beispielsweise können Silberionen in das erste und/oder in das zweite Glaselement eingebracht werden.

Bei der Ionenimplantation können zum Beispiel Silberionen durch ein elektrisches Feld beschleunigt werden und in oberflächennahe Glasbereiche implantiert werden. Beispielsweise kann metallisches Material in den Fügebereich eingebracht werden.

Bei dem lonenaustausch können einwertige Alkaliionen der Glaselemente durch andere einwertige Ionen, zum Beispiel andere Alkaliionen oder Silberionen, ausgetauscht werden. Der lonenaustausch kann sich bis tief in das Glasinnere erstrecken. Eine Ioneneindringtiefe, also ein Abstand zwischen einer Außenkante, von der aus die Ionen eingebracht werden bis hin zu einer Tiefe, die von den eindringenden Ionen erreicht wird, kann beispielsweis e zwischen 0 bis 150µm betragen. Als lonenspender für den lonenaustausch können Salzschmelzen, beispielsweise für den Silber-Natrium-Ionenaustausch oder Pasten oder eine Diffusion aus Feststoffquellen, z.B. aufgesputtertes Silber, Gold, Nickel, Kupfer oder Platin, verwendet werden.

In einer Ausführungsform umfassen/umfasst das erste Glaselement und/oder das zweite Glaselement ein ionenaustauschfähiges Glas, beispielsweise Alumino-, Borsilikatgläser, Dünngläser wie zum Beispiel Corning^{®} Gorilla^{®} Glass, D 263^{®} T eco und BOROFLOAT^{®} 33.

In einer Ausführungsform können die in das erste und/oder in das zweite Glaselement eingebrachten Ionen zu metallischem Material reduziert werden, insbesondere durch Anlegen eines elektrischen Feldes, insbesondere unter Wärmezufuhr.

Der Verfahrensschritt "Einbringen eines metallischen Materials (12) in das erste Glaselement (1) im Bereich des Fügebereichs (11) des ersten Glaselements (1)," kann also umfassen, dass Ionen mittels lonenaustausch und/oder Ionenimplantation in das erste Glaselement (1) eingebracht werden. Der Verfahrensschritt "Einbringen eines metallischen Materials (12) in das erste Glaselement (1) im Bereich des Fügebereichs (11) des ersten Glaselements (1)," kann zudem umfassen, dass die eingebrachten Ionen zu metallischem Material (12) reduziert werden, insbesondere durch Anlegen eines elektrischen Feldes, insbesondere unter Wärmezufuhr. Das metallische Material kann elektrochemisch an einer Kathodenseite des angelegten elektrischen Feldes abgeschieden werden. So kann eine metallische Struktur, insbesondere von wenigen Mikrometern bis durch das Glas hindurch, kontrolliert gebildet werden. Der Wachstumsstart kann von der Glasoberfläche ausgehen. Das metallische Material kann eine vernetzte 3D-Struktur sein.

Das eingebrachte - insbesondere das elektrochemisch abgeschiedene - metallische Material kann elektrisch leitfähig sein. Das metallische Material kann insbesondere wärmeleitfähig sein.

Das metallische Material kann eine vernetzte 3D-Struktur sein. Insbesondere kann das metallische Material in Form von Dendriten vorliegen. Das metallische Material kann zusammenhängende Strukturen aufweisen. Die zusammenhängenden Strukturen können jeweils eine Größe von zumindest 50 nm, vorzugsweise zumindest 80 nm, besonders bevorzugt zumindest 100 nm aufweisen. Die zusammenhängenden Strukturen können jeweils eine Größe von höchstens 200 µm, vorzugsweise höchstens 150 µm, besonders bevorzugt höchstens 100 µm aufweisen.

Das vorliegend beschriebene Verfahren kann sich somit insbesondere von Verfahren unterscheiden, in denen Metallionen als Nanopartikel im Glas vorliegen und diese im Glas verteilt sind. Ein Vorliegen von Nanopartikeln kann beispielsweise zu einer unerwünschten Gelbfärbung des Glases führen. Außerdem bilden Nanopartikel typischerweise eine flächige Schicht. Im Gegensatz zu Dendriten haben Nanopartikel typischerweise eine Größe von 2-50nm. Nanopartikel sind dabei nicht vernetzt und liegen in 1-D vor. Nanopartikel sind nicht elektrisch leitfähig. Nanopartikel sind nicht wärmeleitfähig.

Vorliegend kann das metallische Material, wie oben beschrieben, als elektrisch leitende zusammenhängende Strukturen vorliegen, beispielsweise in Form von Dendriten. Ferner kann das eingebrachte metallische Material im vorliegenden Verfahren derart kontrolliert in dem Glas gebildet sein, dass es lediglich im Bereich des späteren Fügebereiches vorliegt. Dies kann den Vorteil haben, dass ein schwächer fokussierter Laser (beispielsweise im CW-Betrieb, oder eine Flutbelichtung oder eine Induktion) verwendet werden kann, um lokal, d.h. beispielsweise mit einer Genauigkeit kleiner gleich 100 µm, das Glas zu erhitzen. Dies kann insbesondere nicht mit Nanopartikeln, beispielsweise Silbernanopartikeln, erreicht werden, da Nanopartikel keine ausreichend hohe Absorption aufweisen.

Eine Einbringung des metallischen Materials durch elektrisch-chemische Reduktion kann vorteilhaft sein, da dies keinen oder zumindest keinen wesentlichen Unterschied für eine Prozesszeit darstellt. Insbesondere kann es keinen oder zumindest keinen wesentlichen Unterschied für eine Prozesszeit machen, ob beispielsweise eine oder 500 metallische Strukturen in einem Glaselement erzeugt werden. Im Anschluss können diese Strukturen, d.h. das metallische Material, dann mit einer hohen Prozessgeschwindigkeit und niedrigen Toleranzen verschweißt werden.

In einer Ausführungsform kann das erste und/oder das zweite Glaselement können/kann dafür beispielsweise jeweils an zwei Oberflächen mit einem metallischen Material beschichtet werden. Die mit dem metallischen Material beschichteten Oberflächen können elektrisch kontaktiert werden. Mit Hilfe von thermischer und/oder elektrischer Energie kann die Metallbeschichtung an der Kathodenseite reduziert werden.

In einer Ausführungsform können die in das erste und/oder in das zweite Glaselement eingebrachten Ionen zu metallischem Material (auch Nanopartikel, bzw. Cluster) durch weitere Reduktionsmechanismen reduziert werden, beispielsweise thermisch, chemisch und/oder mittels Strahlung (elektromagnetisch, ionisch, mit Elektronen).

Die Reduktion von Ionen kann das metallische Material in dem ersten und/oder in dem zweiten Glaselement in Absorptionsstrukturen umwandeln. Ein Absorptionsgrad kann über eine Partikeldichte einstellbar sein, beispielsweise über eine Silberpartikeldichte. Die Partikeldichte kann mittels des Ionenaustauschverfahrens bzw. lonenimplantationsverfahrens kontrolliert werden.

In einer Ausführungsform kann das metallische Material Silber, insbesondere Silberatome, umfassen.

In einer Ausführungsform kann das metallische Material eine Schichtdicke von mindestens 1 nm, vorzugsweise mindestens 10 nm, besonders bevorzugt mindestens 100 nm aufweisen. Zusätzlich oder alternativ kann das metallische Material eine Schichtdicke von höchstens 5000 nm, vorzugsweise von höchstens 500 nm, besonders bevorzugt von höchstens 100 nm aufweisen.

Die vorliegende Anmeldung betrifft ferner ein Glasbauteil, das ein erstes und ein zweites Glaselement umfasst. Das erste und das zweite Glaselement können durch ein oben beschriebenes Verfahren aneinander gefügt sein.

Das Glasbauteil kann mittels eines Verfahrens gemäß der obigen Beschreibung hergestellt sein.

Das Glasbauteil kann neben dem ersten und dem zweiten Glaselement ein oder mehrere weitere Glaselemente umfassen. Die Glaselemente können mittels eines oben beschriebenen Verfahrens aneinander gefügt sein. Insbesondere können das erste und das zweite Glaselement und, falls vorgesehen, das/die weitere/n Glaselement/e, hermetisch verbunden sein. Insbesondere können die Glaselemente derart ausgebildet und verbunden sein, dass sie einen abgedichteten Innenraum bilden. Der abgedichtete Innenraum kann eine Vakuumkammer, besonders bevorzugt eine Ultrahochvakuumkammer, sein.

In einem Ausführungsbeispiel weist das erste und/oder das zweite Glaselement zumindest ein weiteres metallisches Material auf, das eine metallische Struktur bildet. Der abgedichtete Innenraum kann über zumindest eine metallische Struktur mit einer Umgebung elektrisch kontaktiert werden. Das metallische Material dieser metallischen Struktur kann Teil des metallischen Materials sein, das zum Erhitzen und Verschweißen des ersten und zweiten Glaselements dient. Es kann alternativ auch eine gesonderte Struktur sein. Insbesondere für Sensoren, die in dem abgedichteten Innenraum angeordnet sind, kann es vorteilhaft sein, wenn sie innerhalb des abgedichteten Innenraums geschützt angeordnet sind, sie über die metallische Struktur jedoch elektrisch angesteuert werden können.

In einer Ausführungsform kann das Glasbauteil einen Wafer bzw. ein Substrat mit einer Kappenstruktur umfassen. Das Glasbauteil selbst kann ein Wafer bzw. ein Substrat mit einer Kappenstruktur sein.

Die vorliegende Anmeldung betrifft ferner ein Gehäuse für einen Sensor, einen Aktuator, eine Batterie und/oder eine Linse umfassend ein Glasbauteil mit einigen oder allen der oben beschriebenen Merkmale.

Die vorliegende Anmeldung betrifft ferner eine Vakuumisolierglasscheibe umfassend ein Glasbauteil mit einigen oder allen der oben beschriebenen Merkmale.

Das erfindungsgemäße Verfahren kann sich insbesondere eignen zum Bonden von Kappenstrukturen auf Sensor-, Aktuator-, Batterie- oder MEMS Wafern, zum strukturierten Bonden von Wafern für Image Sensor Packaging oder zur Herstellung von Linsenwafern, zum Wafer Level Glas-Capping und Panel Level Glas-Capping oder für Ultrahochvakuumkammern für die Quantentechnologie.

Vorteilhafte Ausprägungen der Erfindung werden anhand der nachfolgenden Figuren beispielhaft erläutert. Die dargestellten Merkmale und Merkmalskombinationen sind nicht einschränkend zu betrachten, sondern dienen lediglich der Veranschaulichung möglicher Ausprägung der Erfindung.

Es zeigen:
- Figur 1a: zwei Glaselemente in einer schematischen Schnittdarstellung,
- Figur 1b: die zwei Glaselemente der Figur 1a in der schematischen Schnittdarstellung im gefügten Zustand,
- Figur 1c: die zwei Glaselemente der Figuren 1a und 1b in einer schematischen Draufsicht,
- Figur 2a: ein erstes Glaselement in einer schematischen Schnittdarstellung,
- Figur 2b: das Glaselement der Figur 2a mit Silberionen in einer schematischen Schnittdarstellung,
- Figur 2c: das Glaselement der Figur 2b mit den Silberionen an einer Kathodenseite reduziert in einer schematischen Schnittdarstellung und
- Figur 2d: das Glaselement der Figur 2c gefügt mit einem weiteren Glaselement in einer schematischen Schnittdarstellung.

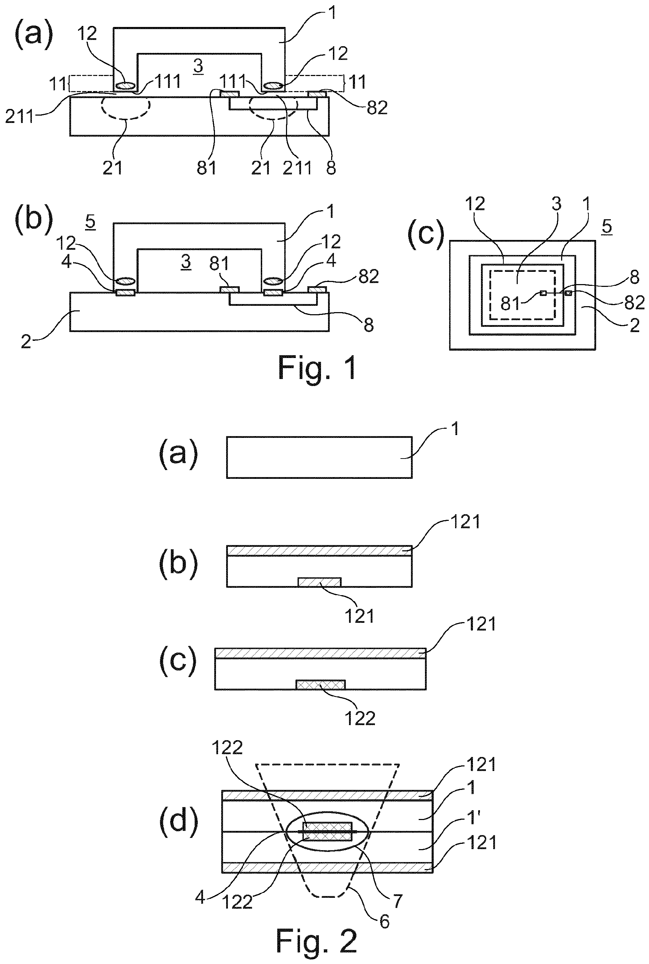

Figur 1a zeigt ein erstes Glaselement 1 und ein zweites Glaselement 2 in einer schematischen Schnittdarstellung. Das erste Glaselement 1 ist vorzugsweise einstückig. Das zweite Glaselement 2 ist vorzugsweise einstückig. Das erste Glaselement 1 hat die Form eines hohlen Quaders ohne Boden. In anderen Ausführungsformen kann das erste Glaselement eine andere Form haben, beispielsweise eine Kuppel mit einer eckigen, elliptischen oder kreisrunden Grundfläche aufweisen und ein Gewölbe in Form einer Halbkugel oder Glocke aufweisen. Auch andere Geometrien, insbesondere quader-, würfelförmige oder pyramidenförmige Ausprägungen können je nach Anwendungsfall vorteilhaft sein. Insbesondere kann es vorteilhaft sein, wenn das erste Glaselement die Form einer Abdeckung oder Haube hat, also eine Form aufweist, die auf eine vorzugsweise ebene Fläche aufgesetzt werden kann und dabei einen Innenraum bildet, in dem Bauteile angeordnet werden können. So kann das erste Glaselement 1 in Verbindung mit einem zweiten Glaselement, beispielsweise einer Glasscheibe wie das dargestellte Glaselement 2, ein Gehäuse bilden.

An einer zu fügenden, unteren Außenkante 111 des ersten Glaselements 1 ist ein Fügebereich 11 vorgesehen. In diesem Fügebereich 11 ist ein metallisches Material 12 in das Glas eingebracht. Im vorliegenden Beispiel hat das metallische Material 12 einen minimalen Abstand zur unteren Außenkante 111 von 20 nm. In anderen Ausführungsbeispielen kann der minimale Abstand beispielsweise mindestens 1 nm, vorzugsweise mindestens 10 nm, besonders bevorzugt mindestens 100 nm. Der minimale Abstand kann beispielsweise höchstens 5000 nm aufweisen, vorzugsweise höchstens 500 nm aufweisen, besonders bevorzugt höchstens 100 nm aufweisen. Selbstverständlich kann der minimale Abstand außerhalb dieser Bereiche liegen, insbesondere wenn das Glaselement 1 größer dimensioniert ist.

Im vorliegenden Beispiel hat das metallische Material 12 eine Schichtdicke von 20nm. In anderen Ausführungsbeispielen kann die Schichtdicke beispielsweise das metallische Material eine Schichtdicke von mindestens 1 nm aufweisen, vorzugsweise mindestens 10 nm aufweisen, besonders bevorzugt mindestens 100 nm aufweisen und/oder eine Schichtdicke von höchstens 5000 nm aufweisen, vorzugsweise von höchstens 500 nm aufweisen, besonders bevorzugt von höchstens 100 nm aufweisen. Die Schichtdicke ist vorzugsweise gleichbleibend, kann in dem Glaselement 1 jedoch auch variieren.

Das metallische Material 12 ist im Fügebereich 11 derart eingebracht, dass es in der Draufsicht (vgl. Figur 1c) eine rechteckig angeordnete Bandform beschreibt.

Das erste Glaselement 1 und das zweite Glaselement 2 sind derart aufeinandergesetzt, dass zwischen den beiden Glaselementen 1 und 2 ein Innenraum 3 gebildet wird. Das erste Glaselement 1 berührt dabei das zweite Glaselement 2 an der Außenkante 111. Das zweite Glaselement berührt das erste Glaselement an einer Außenkante 211. Die Außenkante 211 liegt in einem Fügebereich 21 des zweiten Glaselements 2.

Das metallische Material 12 im ersten Glaselement 1 wird erhitzt, sodass das erste Glaselement 1 im Fügebereich 111 teilweise schmilzt. Es entsteht eine stoffschlüssige Verbindung zwischen dem ersten Glaselement 1 und dem zweiten Glaselement 2 in Form einer Schweißnaht 4, wie sie beispielsweise in Figur 1b gezeigt ist. Der zwischen dem ersten Glaselement 1 und dem zweiten Glaselement 2 gebildete Innenraum 3 ist gasdicht gegenüber einer Umgebung 5 der Glaselemente 1 und 2 abgeschlossen und bildet ein Vakuum.

Das metallische Material 12 wurde mittels elektromagnetischer Wellen eines CW-Lasers erhitzt, dabei absorbierte das metallische Material 12 die Laserstrahlung, was wiederum zu einer Erhitzung von Glasmaterial, das das metallische Material 12 umgibt, führt. Das Glasmaterial, das das metallische Material 12 umgibt, wird dabei lokal auf eine Glasübergangstemperatur erhitzt, sodass es zumindest teilweise schmilzt.

Im vorliegenden Beispiel der Figur 1 ist metallisches Material lediglich in das erste Glaselement 1 eingebracht. Zusätzlich oder alternativ kann metallisches Material in das zweite Glaselement 2 eingebracht sein und dort, beispielsweise ebenfalls mittels eines Lasers, erhitzt werden.

Im zweiten Glaselement 2 ist ein weiteres metallisches Material eingebracht, das eine elektrische Kontaktierung bildet. Die Kontaktierung 8 ermöglicht eine elektrische Kontaktierung des abgedichteten Innenraums 3. Das metallische Material, das die Kontaktierung 8 bildet, kann über lonenaustausch oder über Ionenimplantation gebildet sein. Im Innenraum 3 kann ein elektrisches Bauteil, beispielsweise ein Sensor angeordnet werden, der an einen Kontakt 81 angeschlossen sein kann. Der Kontakt 82 kann an eine Spannungsquelle angeschlossen sein, um das elektrische Bauteil mit Spannung zu versorgen.

Das erste Glaselement 1 und das zweite Glaselement 2 umfassen Borsilikatglas. Das metallische Material 12 ist mittels lonenaustausch in das erste Glaselement 1 eingebracht. Bei den Ionen handelt es sich um Silberionen.

In Figur 1c ist eine Draufsicht des Glaselements 1 und 2 im zusammengesetzten Zustand gezeigt, wobei die rechteckige Quaderform des ersten Glaselements und die Plattenform des zweiten Glaselements gut ersichtlich sind. Die unter dem metallischen Material 12 verlaufende Schweißnaht 4 (nicht dargestellt) dichtet den Innenraum 3 gegenüber der Umgebung 5 gasdicht ab.

Wiederkehrende Merkmale sind in den Figuren mit denselben Bezugszeichen versehen.

In den Figuren 2a bis 2d ist ein beispielhafter Verfahrensablauf einer Glas-Glas-verbindung dargestellt.

In Figur 2a ist ein Ausschnitt eines Glaselements 1 dargestellt. Das Material und die Eigenschaften des dargestellten Glaselements können denen des Glaselements der Figur 1 entsprechen.

In einem nächsten Schritt, der in Figur 2b gezeigt ist, wird das Glaselement 1 präpariert, indem Silberionen 121 mittels lonenaustausch in das Glaselement 1 eingebracht werden. Selbstverständlich können in anderen Ausführungsformen zusätzlich oder alternativ andere Ionen in das Glaselement 1 eingebracht werden.

Beispielsweise können Ionen aus einer festen Phase, zum Beispiel in Form einer Metallfolie oder eines Metallfilms verwendet werden. Hierzu eignen sich beispielsweise metallische Folien umfassend Silber und/oder Kupfer und/oder Gold.

Alternativ können Ionen aus flüssiger Phase, beispielsweise aus Salzschmelzen verwendet werden. Hierfür eignen sich beispielsweise Natriumionen, Kaliumionen, Lithiumionen, Silberionen und/oder Kupferionen.

Alternativ können Sol-Gele verwendet werden, beispielsweise Silberpasten (silver nano-ink).

Anstelle eines lonenaustauschs kann eine Ionenimplantation vorgesehen sein. Hierfür eignen sich beispielsweise Silberionen, Natriumionen, Kaliumionen, Magnesiumionen, Lithiumionen, Kupferionen und/oder Goldionen.

In Figur 2c ist gezeigt, dass die Silberionen an der Kathodenseite zu metallischem Silber 122 reduziert werden. Dafür wird das Glas beidseitig mit Metall beschichtet und ein elektrisches Feld wird an die Metalloberflächen angelegt. Durch thermische und elektrische Energie werden die Silberionen zu metallischem Silber reduziert. Zusätzlich oder alternativ können die Silberionen thermisch, chemisch und/oder mittels Strahlung (elektromagnetisch, ionisch, mit Elektronen) reduziert werden.

Ein weiteres Glaselement 1', das dem der Figur 2c entspricht wird derart auf das erste Glaselement 1 gesetzt, dass die Bereiche, in denen das metallische Silber angeordnet ist, sich berühren. Mit einem Laser wird lokal Energie 6 eingebracht. Dies führt zu einer Energieabsorption im Bereich des metallischen Silbers 122 und einem lokal erhitzen Bereich 7. In dem lokal erhitzen Bereich 7 schmilzt das erste Glaselement 1 sowie das Glaselement 1' zumindest teilweise, sodass eine Schweißnaht 4 gebildet wird und das erste Glaselement 1 und das Glaselement 1' stoffschlüssig zusammengefügt werden.

So können verschiedenen Bausteine aus Glas, ohne die Verwendung von Hilfsstoffen zwischen den Glasoberflächen, stoffschlüssig miteinander verbunden werden. Zusätzlich kann die hohe Leitfähigkeit der Silberstrukturen genutzt werden, um hermetisch abgeschlossene Bereiche elektrisch kontaktieren zu können.

Der hier vorgeschlagene Ansatz verknüpft dabei zwei Phänomene: die lokale und oberflächennahe Änderung der Strahlungsabsorption und das Verschweißen mittels Lasertechnologie. Die Kombination ermöglicht die hohe lokale Präzision der Verbindungsstelle und die deutliche Verringerung der Strahlungsintensität. Daher werden durch diese Idee hochminiaturisierte Aufbauten bei niedrigen Temperaturen ermöglicht. Die Lichtleistung des hierverwendeten Lasers kann klein genug sein, so dass keine wesentlichen Änderungen im Glas entstehen. Die Selektivität des Schweißprozesses kann durch die geometrische Genauigkeit der Silberstrukturen begrenzt werden. Zudem kann durch das vorliegende Verfahren ein vergleichsweise höherer möglicher Arbeitsabstand ermöglicht werden, der insbesondere für das Fügen innerhalb einer großen Vakuumkammer, wichtig sein kann.

## Patentansprüche

1. Verfahren zum stoffschlüssigen Fügen von Glaselementen, umfassend die folgenden Schritte
- Bereitstellen eines ersten (1) und eines zweiten Glaselements (2), wobei jedes der Glaselemente (1, 2) zumindest einen Fügebereich (11, 12) mit einer zu fügenden Außenkante aufweist,
- Einbringen eines metallischen Materials (12) in das erste Glaselement (1) im Bereich des Fügebereichs (11) des ersten Glaselements (1),
- Aufeinandersetzen des ersten (1) und zweiten Glaselements (2), derart, dass sich das erste (1) und das zweite Glaselement (2) an zumindest einer zu fügenden Außenkante (111, 211) des jeweiligen Fügebereichs (11, 21) berühren,
- Erhitzen des metallischen Materials (12) im ersten Glaselement (1), sodass das erste Glaselement (1) im Bereich des Fügebereichs des ersten Glaselements (1) zumindest teilweise schmilzt, sodass eine stoffschlüssige Verbindung zwischen dem ersten (1) und dem zweiten Glaselement (2) entsteht.

2. Verfahren nach Anspruch 1, **dadurch gekennzeichnet, dass** das metallische Material elektrisch leitfähig ist und/oder dass das metallische Material in Form von Dendriten vorliegt.

3. Verfahren nach einem der vorhergehenden Ansprüche, **dadurch gekennzeichnet, dass** das metallische Material zusammenhängende Strukturen aufweist, insbesondere wobei
die zusammenhängenden Strukturen jeweils eine Größe von zumindest 50nm, vorzugsweise zumindest 80 nm, besonders bevorzugt zumindest 100 nm aufweisen.

4. Verfahren nach einem der vorhergehenden Ansprüche, **dadurch gekennzeichnet, dass** im Schritt
"Einbringen eines metallischen Materials (12) in das erste Glaselement (1) im Bereich des Fügebereichs (11) des ersten Glaselements (1),"
Ionen mittels lonenaustausch und/oder Ionenimplantation in das erste Glaselement (1) eingebracht werden und
dass die eingebrachten Ionen zu metallischem Material (12) reduziert werden, insbesondere durch Anlegen eines elektrischen Feldes, insbesondere unter Wärmezufuhr.

5. Verfahren nach Anspruch 4, **dadurch gekennzeichnet, dass** das metallische Material elektrochemisch an einer Kathodenseite abgeschieden wird.

6. Verfahren nach einem der vorhergehenden Ansprüche, **dadurch gekennzeichnet, dass** das Erhitzen des metallischen Materials (12) durch Einbringen von elektromagnetischen Wellen und/oder Anlegen eines Stroms an das metallische Material (12) erfolgt.

7. Verfahren nach einem der vorhergehenden Ansprüche, **dadurch gekennzeichnet, dass** das Erhitzen derart erfolgt, dass das zweite Glaselement (2) im Fügebereich (21) erhitzt wird und zumindest teilweise schmilzt.

8. Verfahren nach einem der vorhergehenden Ansprüche, **dadurch gekennzeichnet, dass** elektromagnetische Wellen mittels einer Lichtquelle, vorzugsweise einem Laser oder mittels einer Mikrowellenstrahlungsquelle, in das erste Glaselement (1) eingebracht werden.

9. Verfahren nach einem der vorhergehenden Ansprüche, **dadurch gekennzeichnet, dass** das zweite Glaselement (2) metallisches Material (12) umfasst.

10. Verfahren nach einem der vorhergehenden Ansprüche, **dadurch gekennzeichnet, dass** das metallische Material (12) Silber, insbesondere Silberatome, umfasst.

11. Verfahren nach einem der vorhergehenden Ansprüche, **dadurch gekennzeichnet, dass** das metallische Material (12) eine Schichtdicke von mindestens 1 nm aufweist, vorzugsweise mindestens 10 nm aufweist, besonders bevorzugt mindestens 100 nm aufweist,
und/oder
eine Schichtdicke von höchstens 5000 nm aufweist, vorzugsweise von höchstens 500 nm aufweist, besonders bevorzugt von höchstens 100 nm aufweist.

12. Glasbauteil hergestellt mittels eines Verfahrens gemäß einem der vorhergehenden Ansprüche, umfassend das erste und das zweite Glaselement, wobei das erste (1) und das zweite Glaselement (2) hermetisch verbunden sind und das erste (1) und das zweite Glaselement (2) vorzugsweise derart ausgebildet und verbunden sind, dass sie eine Vakuumkammer, besonders bevorzugt eine Ultrahochvakuumkammer, bilden.

13. Glasbauteil gemäß Anspruch12, **dadurch gekennzeichnet, dass**
das Glasbauteil einen Wafer bzw. ein Substrat mit einer Kappenstruktur umfasst oder ist.

14. Gehäuse für einen Sensor, einen Aktuator, eine Batterie und/oder eine Linse umfassend ein Glasbauteil gemäß einem der Ansprüche 12 oder 13.

15. Vakuumisolierglasscheibe umfassend ein Glasbauteil gemäß einem der Ansprüche 12 oder 13.
